(19) Europäisches Patentamt

European Patent Office

Office européen des brevets

(11) **EP 0 682 222 B1**

(12) **FASCICULE DE BREVET EUROPEEN**

(45) Date de publication et mention
de la délivrance du brevet:
**12.04.2000 Bulletin 2000/15**

(51) Int Cl.7: **F27B 17/02**, C30B 30/08,
F27D 3/00, B64G 1/22

(21) Numéro de dépôt: **95401076.5**

(22) Date de dépôt: **10.05.1995**

(54) **Dispositif de chargement d'un four spatial automatique**

Automatische Ladevorrichtung für einen Ofen im Weltraum

Automatic charging device for a furnace in space

(84) Etats contractants désignés:
**DE ES**

(30) Priorité: **13.05.1994 FR 9405892**

(43) Date de publication de la demande:
**15.11.1995 Bulletin 1995/46**

(73) Titulaire: **SOCIETE NATIONALE D'ETUDE ET DE
CONSTRUCTION DE MOTEURS D'AVIATION,
"S.N.E.C.M.A."
75015 Paris (FR)**

(72) Inventeur: **Valentian, Dominique
F-78710 Rosny (FR)**

(74) Mandataire: **Thévenet, Jean-Bruno et al
Cabinet Beau de Loménie
158, rue de l'Université
75340 Paris Cédex 07 (FR)**

(56) Documents cités:
• **JOURNAL OF CRYSTAL GROWTH, vol.71, no.1,
1 Janvier 1985, AMSTERDAM pages 173 - 175
A.EYER 'FLOATING ZONE GROWTH OF
SILICON UNDER MICROGRAVITY IN A
SOUNDING ROCKET'**
• **ESA BULLETIN, no.31, 1 Août 1982 pages 34 - 45
U.HUTH 'THE MATERIALS-SCIENCE ELEMENT
OF THE FIRST SPACE LAB PAYLOAD'**

## Description

Domaine de l'invention

La présente invention concerne d'une façon générale les mécanismes de commande de fours installés sur des stations spatiales ou des satellites et devant fonctionner de façon automatique pendant de longues périodes, de l'ordre de plusieurs mois jusqu'à l'intervention d'un spationaute ou la récupération du satellite.

Les fours spatiaux automatiques permettent de procéder à divers traitements en microgravité sur des échantillons placés dans des cartouches fermées de façon étanche.

A titre d'exemples de traitements dans des fours spatiaux, on peut noter la solidification orientée, notamment de semiconducteurs tels que l'arséniure de gallium, l'antimoniure et le phosphure d'indium, ou encore la solidification en phase vapeur, notamment par épitaxie, concernant par exemple du tellure de cadmium dopé au mercure.

La présente invention concerne plus particulièrement un dispositif de chargement et de déchargement de four permettant d'introduire de façon automatique dans un four, puis de retirer de celui-ci, de façon individuelle, au cours d'une mission dans l'espace sans intervention humaine, des cartouches fermées étanches préalablement préparées au sol et stockées dans un magasin disposé dans une station spatiale ou un satellite au voisinage d'un four de traitement.

Art antérieur

On connaît déjà, notamment par la communication de R. SRINIVAS et D. SCHAEFER intitulée : "IAF-87-406 Multiple Experiment Processing Furnace (MEPF) : An Overview" effectué au 38e congrès de la Fédération Astronautique Internationale (IAF) qui s'est tenu à Brighton, UK du 10 au 17 octobre 1987, des dispositifs automatiques d'échange d'échantillons dans des fours spatiaux.

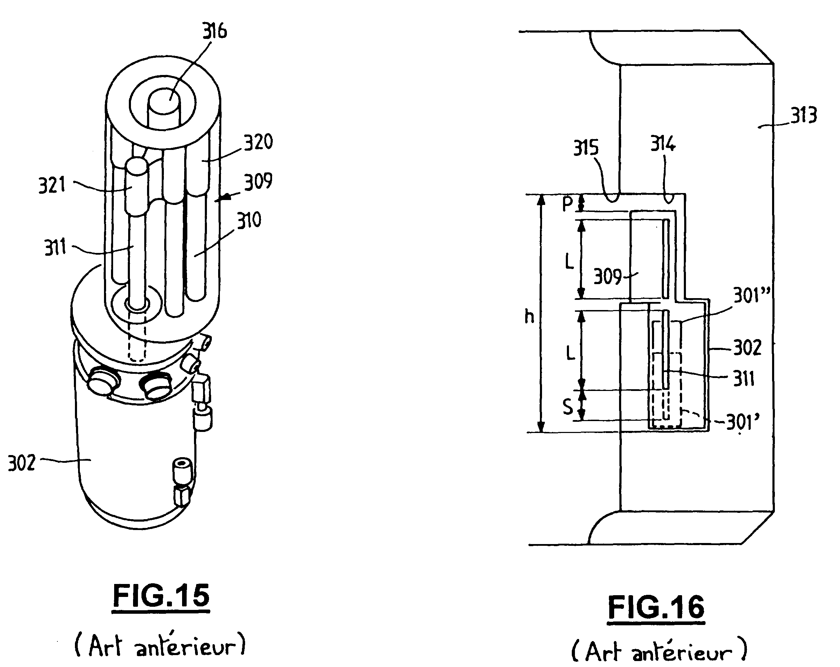

Dans de telles réalisations connues, les échantillons sont placés dans des cartouches fermées 310 elles-mêmes disposées dans des supports ou pieds de cartouches 320 montés sous la forme d'un barillet dans un magasin de stockage cylindrique 309 qui est placé dans le prolongement de l'ensemble 302 constituant une enceinte dans laquelle se trouve le four de traitement (figures 15 et 16). Le magasin de stockage 309 présente un axe de rotation parallèle à l'axe géométrique longitudinal du four, mais décalé par rapport à celui-ci de façon que, par rotation du barillet, les cartouches 310 viennent successivement dans des positions 311 qui sont alignées avec l'axe géométrique longitudinal du four. Le support 321 de la cartouche 311 destinée à être introduite dans le four est alors saisi par un mécanisme 316 assurant une translation en direction du four. Le four 301 est lui-même équipé d'un mécanisme d'entraînement en translation (non représenté sur les dessins) le long de tiges-guides afin de pouvoir soumettre l'échantillon placé dans la cartouche de travail 311 dans différentes zones de température, comme cela est requis par exemple pour réaliser une solidification.

Les fours spatiaux automatiques de l'art antérieur tels que ceux décrits dans l'article précité font ainsi appel à trois mécanismes différents et indépendants pour effectuer les opérations de chargement-déchargement des cartouches ainsi que le traitement des échantillons des cartouches en position de travail, à savoir : un mécanisme d'entraînement en rotation du barillet disposé dans le magasin 309 de stockage des cartouches 310, un mécanisme 316 de translation de la cartouche 311 devant être chargée ou déchargée et un mécanisme d'entraînement en translation du four de traitement 301. Les dispositifs de chargement de four spatial automatique connus sont donc relativement complexes et délicats à réaliser, d'autant plus que la cartouche 311 contenant un échantillon à traiter, qui comporte un connecteur muni de contacts électriques pour différents signaux de mesure, doit, lorsqu'elle est en position de travail, permettre une connexion correcte de ce connecteur avec un connecteur complémentaire associé au four. La réalisation de connecteurs à enfichage automatique dans des dispositifs soumis à des translations de grande amplitude pose des problèmes d'alignement et de force d'insertion.

Les dispositifs de chargement de four de l'art antérieur du type à translation de cartouches à partir d'un magasin superposé au four conduisent également à un encombrement très important alors que les volumes disponibles sont toujours réduits dans les stations spatiales ou les satellites.

Ainsi, si l'on considère la figure 16, on voit que le montage traditionnel d'une chambre de process 302 contenant un four et de l'ensemble de chargement automatique 309 du four, dans un logement 314 formé dans la paroi 313 d'un véhicule spatial, nécessite que le logement 314 présente une hauteur totale h minimale telle que :

$$h > 2L + s + P$$

où

L = longueur de la cartouche 311 ;
s = course du four, par exemple pour un processus de solidification, entre des positions 301' et 301";
P = espace supplémentaire pour permettre la manipulation du barillet 309 (de l'ordre de 10 cm environ).

En pratique, la hauteur h, qui dépend naturellement du type de four, est en général au moins de l'ordre de 1 m et l'ouverture 315 permettant l'échange de magasin 309 doit au moins être égale à L+P, soit en pratique de l'ordre de 50 à 60 cm.

Objet et description succincte de l'invention

L'invention vise à remédier aux inconvénients précités des dispositifs de l'art antérieur et notamment à simplifier les dispositifs mécaniques de positionnement et d'échange automatique des cartouches entre un magasin de stockage et ce four de travail.

L'invention vise plus particulièrement à réaliser un dispositif de chargement-déchargement de four spatial qui soit compact, léger, simple, fiable et ne crée pas de moments cinétiques et quantités de mouvements pouvant affecter la stabilité du satellite ou de la station incorporant le dispositif.

L'invention vise encore à permettre d'effectuer des connexions électriques plus sûres entre une cartouche en position de travail et la structure de support du four de traitement.

Ces buts sont atteints grâce à un dispositif de chargement d'un four spatial automatique de traitement comportant un axe géométrique longitudinal et des moyens pour entraîner en translation de façon guidée le four le long dudit axe géométrique longitudinal, le dispositif de chargement étant disposé au voisinage du four et comprenant un barillet porte-cartouches dont l'axe de rotation est parallèle à l'axe géométrique longitudinal du four et qui est muni d'un ensemble de pieds de cartouche dans lesquels sont montées de façon amovible des cartouches fermées étanches destinées à contenir chacune un échantillon à traiter dans ledit four spatial et disposées dans le barillet parallèlement à l'axe de rotation de celui-ci, un mécanisme de commande d'entraînement en rotation des pieds de cartouche avec indexation et un mécanisme de transfert coopérant avec chaque pied de cartouche du barillet pour permettre à chaque cartouche de venir successivement prendre une position de travail dans laquelle l'axe de la cartouche est aligné avec l'axe géométrique du four, caractérisé en ce que le barillet est lui-même monté latéralement par rapport au four, en ce que le mécanisme de transfert comporte un bras de translation perpendiculaire à l'axe de rotation du barillet en ce que le mécanisme de commande d'entraînement en rotation des pieds de cartouche et le mécanisme de transfert sont activés en alternance à partir d'un moteur électrique unique et en ce que le moteur électrique unique, le mécanisme de commande d'entraînement en rotation des pieds de cartouche et le mécanisme de transfert sont disposés dans l'espace central libre du barillet porte-cartouches.

L'invention permet, vis-à-vis des systèmes existants, de réduire l'encombrement de l'ensemble four spatial et dispositif de chargement et aussi de réduire la masse de l'ensemble par la suppression d'un mécanisme. Lorsqu'une cartouche destinée à être engagée dans le four a été déplacée latéralement par le mécanisme de transfert en restant parallèle à l'axe de rotation du barillet, l'engagement de la cartouche dans le four peut être effectué par la simple translation du four. Le mécanisme de transfert est lui-même intimement lié au mécanisme de commande d'entraînement en rotation des pieds de cartouche, ce qui permet d'avoir un ensemble plus compact et un seul moteur de commande.

La plus grande simplicité du système augmente la fiabilité de l'ensemble, ce qui est une caractéristique très importante pour le matériel spatial, le non-fonctionnement d'un four entraînant une perte importante et l'intervention exceptionnelle d'un spationaute représentant une dépense élevée.

Dans le cas fréquent où les échantillons comprennent des produits très toxiques, le barillet ainsi que les mécanismes de commande d'entraînement en rotation des pieds de cartouche et de transfert sont placés à l'intérieur d'un conteneur hermétique muni d'une ouverture latérale obturable, de façon à apporter une sécurité contre d'éventuelles fuites des cartouches pendant le transport jusqu'à la mise en orbite. La porte obturant l'ouverture est ouverte sélectivement pour permettre le passage d'une cartouche pendant les opérations de traitement dans l'espace.

Le four et le barillet peuvent être installés selon différentes configurations qui sont toutes plus compactes que les systèmes pour lesquels les cartouches sont transférées dans le four par translation à partir d'un magasin situé dans le prolongement du four.

Selon un mode particulier de réalisation, le mécanisme de commande d'entraînement en rotation des pieds de cartouche comprend un axe qui est disposé perpendiculairement au bras de translation, reçoit à l'une de ses extrémités un mouvement de rotation initié par le moteur électrique et entraîne à son autre extrémité un dispositif à croix de Malte agissant sur les pieds de cartouche.

Dans ce cas, de façon plus particulière, le mécanisme à croix de Malte comprend un doigt de commande de rotation agissant sur des gorges formées dans les pieds de cartouche parallèlement à l'axe du barillet et une came coopérant avec des alvéoles formées dans les pieds de cartouche pour assurer un verrouillage à chaque indexation.

Le mécanisme de transfert comprend au moins deux bras articulés d'une part sur une console fixée sur le fond du barillet perpendiculairement à ce fond et d'autre part sur le bras de translation pour constituer avec le bras de translation une structure en parallélogramme.

Le bras de translation présente des parties saillantes pouvant venir se loger dans des gorges de profil complémentaire formées dans les pieds de cartouche, lorsqu'un pied de cartouche est positionné en face du bras de translation.

Selon un premier mode de réalisation possible, le mécanisme de transfert comprend un guide fixé sur le bras de translation perpendiculairement à celui-ci, un doigt engagé dans le guide et solidaire d'un plateau dont le plan est parallèle à ladite console et qui peut être entraîné sélectivement à travers un dispositif d'embrayage à partir d'une roue dentée d'entraînement dont l'axe est perpendiculaire au plan de la console et qui est en prise avec un pignon réducteur disposé en sortie du moteur électrique.

Le mécanisme de commande d'entraînement en rotation des pieds de cartouche comprend un disque dont le plan est parallèle à la console, qui est solidaire de l'axe auquel est rattaché le dispositif à croix de Malte et qui peut être entraîné sélectivement à travers le dispositif d'embrayage à partir de la roue dentée d'entraînement lorsque le plateau du mécanisme de transfert est lui-même débrayé par rapport à la roue dentée d'entraînement.

De préférence, des éléments élastiques sont interposés entre le guide et le bras de translation.

Selon ce premier mode de réalisation, lors d'une rotation de deux tours de la roue dentée d'entraînement, lors du premier tour correspondant à une rotation d'un pas du barillet et au verrouillage des pieds de cartouche, le disque solidaire de l'axe auquel est rattaché le dispositif à croix de Malte est embrayé sur la roue dentée d'entraînement pendant que le plateau du mécanisme de transfert est débrayé de la roue dentée d'entraînement, et lors du deuxième tour correspondant à une étape d'extraction d'une cartouche du barillet, de traitement de la cartouche extraite dans le four et de remise en place de la cartouche, le disque solidaire de l'axe auquel est rattaché le dispositif à croix de Malte est débrayé de la roue dentée d'entraînement tandis que le plateau du mécanisme de transfert est embrayé sur la roue dentée d'entraînement.

Selon un deuxième mode de réalisation, lors d'une rotation d'un tour de la première roue dentée d'entraînement, pendant le premier demi-tour, la structure en parallélogramme du mécanisme de transfert est maintenue immobile en position rentrée grâce à un profil de la came en demi-cercle centré sur la première roue dentée d'entraînement, tandis que la rotation des première et deuxième roues dentées d'entraînement détermine la rotation des pieds de cartouche d'un pas, et, pendant le deuxième demi-tour, la rotation de la deuxième roue dentée verrouille le barillet dans sa position acquise précédemment tandis que la rotation de la première roue dentée entraînant le doigt dans une partie arquée de retour de la came provoque pendant la première moitié du deuxième demi-tour une avance du bras de translation amenant une cartouche en position de travail dans le four, et pendant la deuxième moitié du deuxième demi-tour une rétraction du bras de translation ramenant la cartouche traitée dans le barillet.

Dans le cas où un dispositif d'embrayage est utilisé, celui-ci peut être de type actif et constitué par exemple à l'aide d'un électroaimant, ou de type passif.

Selon un mode particulier de réalisation, le dispositif d'embrayage est de type passif et comprend un élément actuateur muni de deux paires de faces planes opposées, qui tourillonne dans la roue dentée d'entraînement et coopère avec une molette en forme de croix qui possède quatre positions stables et subit à chaque tour de la roue dentée d'entraînement sous l'effet d'un doigt une rotation de 90° qui a pour effet de verrouiller l'élément actuateur soit dans une empreinte taillée dans le disque soit dans une empreinte taillée dans le plateau.

Selon un aspect particulier de l'invention, chaque pied de cartouche comprend une interface essentiellement plane de positionnement mécanique et de connexion électrique adaptée pour coopérer avec une interface complémentaire unique essentiellement plane de positionnement mécanique et de connexion électrique disposée sur des moyens de support des moyens d'entraînement en translation du four.

Brève description des dessins

D'autres caractéristiques et avantages de l'invention ressortiront de la description suivante de modes particuliers de réalisation donnés à titre d'exemples non limitatifs, en référence aux dessins annexés, sur lesquels :

- la figure 1 est une vue schématique en coupe axiale d'un four spatial automatique équipé d'un dispositif d'échange de cartouches latéral, conforme à l'invention, dans lequel un lot de cartouches est introduit axialement,
- la figure 2 est une vue schématique en coupe axiale d'un four spatial à montage vertical associé à un dispositif d'échange de cartouches latéral conforme à l'invention,
- les figures 3 et 4 sont des vues en élévation d'un premier mode de réalisation d'un dispositif de chargement de four selon l'invention, respectivement en position rétractée et en position de chargement,
- les figure 5 et 6 sont des vues de dessus respectivement du dispositif de chargement de four des figures 3 et 4,
- la figure 7 est un diagramme montrant un cycle de fonctionnement du dispositif des figures 3 à 6,
- la figure 8 est une vue de détail en perspective avec éclatement montrant la liaison entre un bras de transfert d'un dispositif selon l'invention et un pied de cartouche,
- la figure 9 est une vue en perspective d'une partie du dispositif de chargement de four des figures 3 à 6 montrant les organes d'entraînement en rotation et translation,
- les figures 10A à 10C montrent en élévation des détails de réalisation d'un dispositif d'embrayage de type passif applicable au mode de réalisation des figures 3 à 6,
- la figure 11 est une vue en élévation d'un deuxième mode de réalisation d'un dispositif de chargement de four selon l'invention, placé en position rétractée,

- la figure 12 est une vue en perspective montrant un dispositif de chargement de four selon l'invention placé dans une enceinte munie d'un ouverture obturable,
- la figure 13 montre en perspective un mode particulier de réalisation d'un mécanisme de commande d'entraînement en rotation de barillet applicable à la présente invention,
- la figure 14 est une vue en perspective d'un dispositif de connexion électrique applicable au dispositif d'échange de cartouches selon l'invention,
- la figure 15 est une vue en perspective d'un four spatial associé à un dispositif d'échange de cartouches selon l'art antérieur,
- la figure 16 est une vue schématique en coupe axiale d'un four spatial vertical associé à un dispositif connu d'échange de cartouches placé dans le prolongement du four, et
- les figures 17a, 17b et 17c montrent un four en deux parties auquel est applicable un dispositif d'échange de cartouches conforme à l'invention, le four présentant respectivement deux parties alignées, deux parties superposées mais présentant des axes décalés et deux parties juxtaposées présentant des axes décalés.

Description détaillée de modes particuliers de réalisation

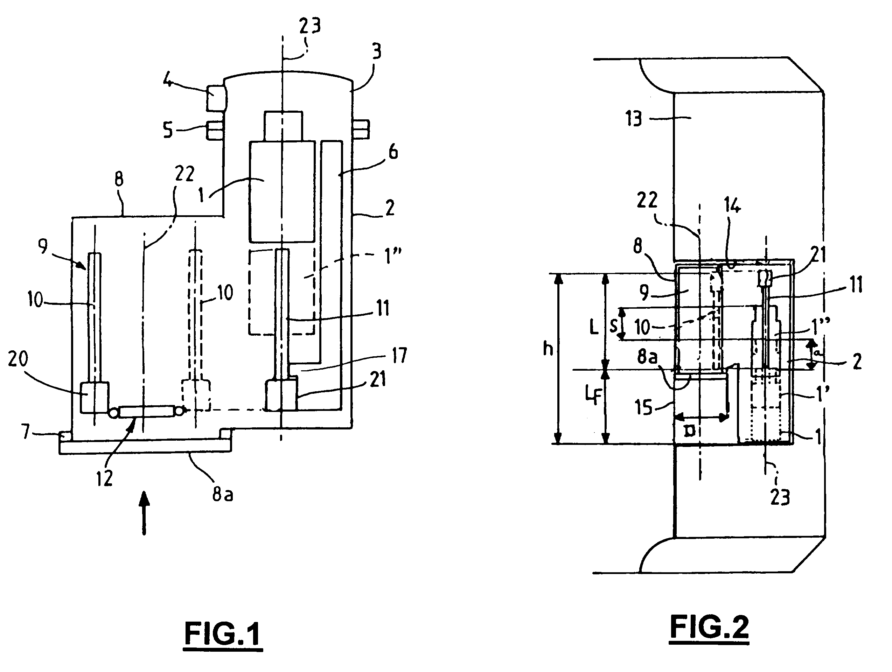

On considérera tout d'abord la figure 1 qui montre une enceinte 2 de four spatial définissant une chambre de process destinée à être installée dans un logement au sein d'un satellite ou d'une station spatiale.

La référence 3 désigne une partie démontable de l'enceinte 2, qui est munie d'organes 4 de traversée étanche et se trouve raccordée au corps principal de l'enceinte 2 par une liaison à brides 5.

Un four 1 proprement dit est introduit dans l'enceinte 2 lorsque la partie 3 est démontée, et se trouve monté sur un dispositif de support 6, qui peut par exemple comporter des colonnettes ou une table-guide, de telle manière que le four 1 peut se déplacer en translation selon son axe géométrique longitudinal 23 afin de venir dans la position 1" représentée en pointillé sur la figure 1. Le mécanisme de translation du four 1 le long du dispositif de support 6 peut lui-même être classique.

Un compartiment 8 contenant un lot de cartouches 10 et un mécanisme de chargement et de déchargement des cartouches 10 est également rapporté sur le corps principal de l'enceinte 2, latéralement, et se trouve relié à l'enceinte 2 par une liaison à brides 7.

Conformément à l'invention, le lot de cartouches 10 est monté à l'intérieur du compartiment 8 dans des pieds de cartouche 20 qui sont montés de façon à constituer un barillet 9. Selon une caractéristique essentielle, l'axe de rotation 22 du barillet 9, auquel sont parallèles les cartouches 10 en position de repos stockées dans le compartiment 8, est parallèle à l'axe géométrique longitudinal 23 du four 1.

Grâce à la disposition particulière du compartiment 8 de stockage des cartouches 10 à proximité immédiate du four 1, à côté de celui-ci, l'enceinte 2 peut être très compacte et, surtout, chaque cartouche 10 peut être introduite très facilement dans le four 1, par un simple mouvement de translation latérale du pied de cartouche 20 selon un axe perpendiculaire à l'axe 22 du barillet 9 et à l'axe géométrique 23 du four 1. Le mécanisme 12 d'entraînement en rotation du barillet 9 avec indexation, pour amener une nouvelle cartouche 10 au voisinage du four 1, coopère avec des moyens assurant la commande du transfert de la cartouche 10 pour amener le pied de cartouche 20 et la cartouche 10 dans une position de travail. Le pied de cartouche et la cartouche en position de travail sont désignés respectivement par les références 21 et 11 sur les dessins. Lorsque, par un simple mouvement de translation latérale déclenché par le mécanisme 12 d'entraînement en rotation du barillet, la cartouche 11 se trouve alignée avec l'axe 23 du four 1, il suffit de positionner la cartouche 11 dans la position longitudinale souhaitée par rapport au four 1 par une simple translation du four 1 le long de son support 6. Sur la figure 1, on a représenté en pointillé une position 1" dans laquelle la cartouche 11 est engagée pratiquement totalement dans le four.

Dans le cas du mode de réalisation de la figure 1, un couvercle 8a est disposé à la partie inférieure du compartiment 8 pour permettre d'introduire ou de retirer le lot de cartouches 10 et le barillet 9 axialement. Selon un variante de réalisation, l'ouverture de chargement du barillet 9 pourrait être latérale.

La figure 2 montre un exemple d'agencement, dans un véhicule spatial, d'une enceinte 2 contenant un four 1, un compartiment 8 de stockage de cartouches 10 ainsi qu'un mécanisme de translation de four et un mécanisme d'entraînement en rotation du barillet et de transfert de cartouche (non représentés), l'ensemble constituant une chambre de process.

L'enceinte 2 est montée à travers une ouverture 15 dans un logement 14 d'une paroi 13 de véhicule spatial.

Sur la figure 2, le four 1 est placé verticalement, c'est-à-dire parallèlement à la paroi 13, tandis que le compartiment 8 et le barillet qu'il contient sont également parallèles à la paroi 13 et situés latéralement par rapport au four 1.

Dans le montage de la figure 2, la hauteur totale h de l'enceinte 2 doit être telle que :

$$h > L + L_f$$

où

L = longueur de cartouche

$L_f$ = longueur du four, soit de l'ordre de 80 % de la longueur L en pratique

D = diamètre du compartiment 8 contenant le barillet 9

On constate que la hauteur minimale h dans le cas du montage de la figure 2 est de l'ordre de 35 à 45 % plus faible que la hauteur minimale requise dans un montage traditionnel tel que celui de la figure 16. En particulier, la course s du four 1 entre ses positions extrêmes 1' et 1'' lors du traitement d'un échantillon, par exemple pour réaliser une solidification, n'intervient plus dans la détermination de la hauteur minimale du logement 14. De même le diamètre D du compartiment 8 n'intervient plus que pour le positionnement latéral de ce compartiment et n'est pas une contrainte pour la détermination de la hauteur totale de l'enceinte.

A titre d'exemple pour les paramètres du montage des figures 2 et 16, des valeurs typiques peuvent être :

$$L = 400 \text{ mm} \qquad P = 100 \text{ mm}$$
$$L_f = 300\text{mm} \qquad D = 200 \text{ mm}$$
$$s = 120 \text{ mm}$$

Dans ce cas, la valeur minimale pour la hauteur h est $h_1$ = 650 mm pour le montage de la figure 2, et $h_2$ = 1 020 mm pour le montage de la figure 16.

On peut remarquer par ailleurs que la cartouche 11 étant déplacée latéralement vers sa position de travail par translation et non par basculement, il n'y a pas lieu de laisser une longueur libre entre la position de début de tirage du four (repérée 1'' sur la figure 2) et le pied de cartouche pour tenir compte du diamètre du four. La réduction de la hauteur minimale h par rapport à un mécanisme de chargement du type à basculement de cartouches est donc là encore très sensible, et peut être en pratique de l'ordre de 20 à 30%.

En particulier dans le cas de cartouches de grande taille présentant par exemple une longueur L = 800 mm, un diamètre D = 60 mm, avec une longueur de four $L_F$ = 600 mm, le gain pour la hauteur minimale h est important par rapport à des mécanismes du type à basculement.

L'invention peut toutefois combiner des mouvements de translation et de basculement ou pivotement. Ainsi, l'invention est applicable à des fours à deux zones chauffantes 1a, 1b présentant des longueurs $L_{F1}$, $L_{F2}$ par exemple de chacune 300 mm. Dans ce cas, la hauteur totale de l'instrument peut être réduite si l'on opère un pivotement de l'une des zones 1b en fin de course et une translation de l'autre zone 1a. Dans le cas de cartouches de grande taille présentant une longueur L = 800 mm, la hauteur totale h ne sera égale qu'à L + $L_{F2}$ = 1100 mm.

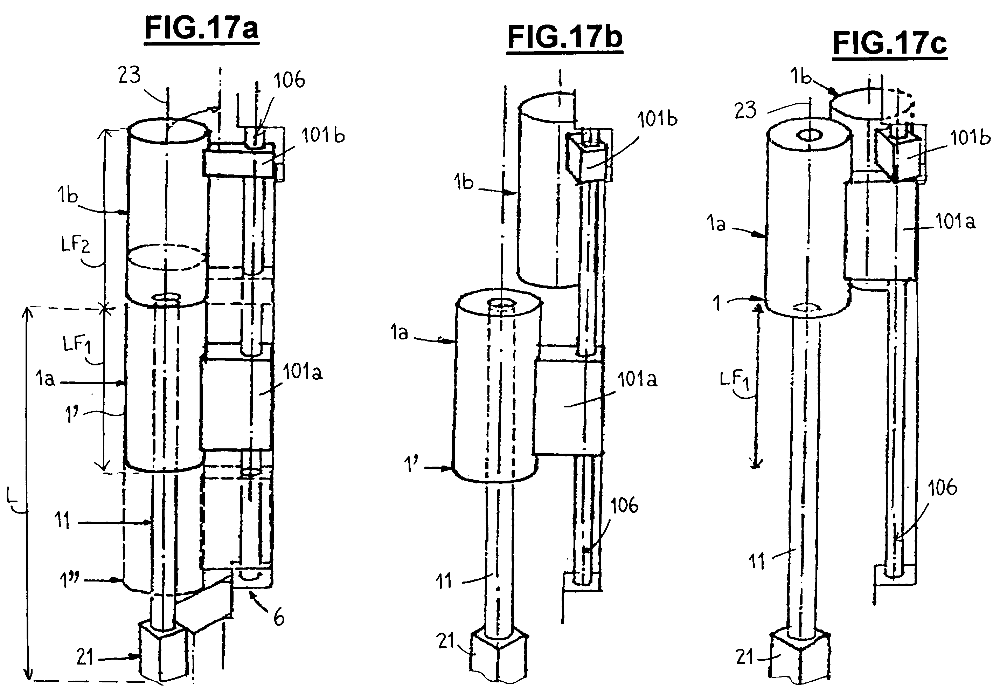

La figure 17a montre le four en position 1' avec les deux zones chauffantes de longueur $L_{F1}$ et $L_{F2}$ définies par des blocs 1a, 1b qui sont superposés et alignés selon un axe 23 avec lequel coïncide également l'axe de la cartouche 11 en cours de traitement. La position de l'ensemble du four 1'' correspondant au début de la solidification est représentée en traits interrompus. Le support latéral 6 du four comprend une colonne 106 dont l'axe est parallèle à l'axe 23 selon lequel le four 1a, 1b est positionné. Les deux blocs 1a, 1b du four sont reliés au support latéral 6 par des éléments de liaison 101a, 101b pouvant coulisser le long de la colonne 106 ou pivoter autour de cette colonne.

La figure 17b montre le four dans une position de fin de travail faisant suite à la position en traits pleins de la figure 17a. Dans cette position de la figure 17b, le bloc 1b et son élément de liaison 101b ont pivoté autour de la colonne 106.

Le bloc 1a est lui-même resté dans la position 1' de la figure 17a, c'est-à-dire se trouve disposé au-dessous du bloc 1b, mais décalé angulairement par rapport au bloc 1b qui constitue l'élément le plus éloigné du pied 21 de la cartouche à traiter 11.

La figure 17c montre le four dans une position 1 dans laquelle le bloc 1a a été déplacé en translation d'une distance $L_{F1}$ selon l'axe 23 et se trouve placé à côté du bloc 1b qui a été escamoté par pivotement, de telle sorte que la cartouche 11 peut être évacuée et une nouvelle cartouche peut être mise en place. Dans la position de la figure 17c, le four présente un encombrement réduit en hauteur puisque les deux blocs 1a et 1b sont situés côte à côte, et ne sont plus alignés comme dans la position de travail de la figure 17a.

La présente invention se révèle particulièrement utile lorsque le four 1 ou un éventuel aimant entourant le four, présente un diamètre important.

En effet, le diamètre du four n'intervient pas pour la détermination de la hauteur totale h de l'enceinte 2 et la place disponible dans le barillet 9 autorise un éloignement de l'axe du four 23 vis-à-vis du barillet qui est égal au diamètre moyen de stockage des cartouches diminué de deux fois la largeur du pied de cartouche.

Le mode de chargement ou de déchargement des cartouches 10 dans le barillet 9 et le compartiment 8 entre deux missions peut être très varié. Ainsi, sur le mode de réalisation de la figure 2, les cartouches 10 peuvent être installées dans le compartiment 8 ou retirées de celui-ci en enlevant un couvercle 8a situé du côté opposé aux pieds de cartouche, de sorte que les cartouches peuvent être manipulées sans traverser les pieds de cartouche.

Toutefois, dans le mode de réalisation de la figure 1, le couvercle 8a est situé du côté des pieds de cartouche 20, de sorte que le chargement et le déchargement d'un lot de cartouches 10 s'effectuent à travers les pieds de cartouche 20 entre deux séquences de traitement.

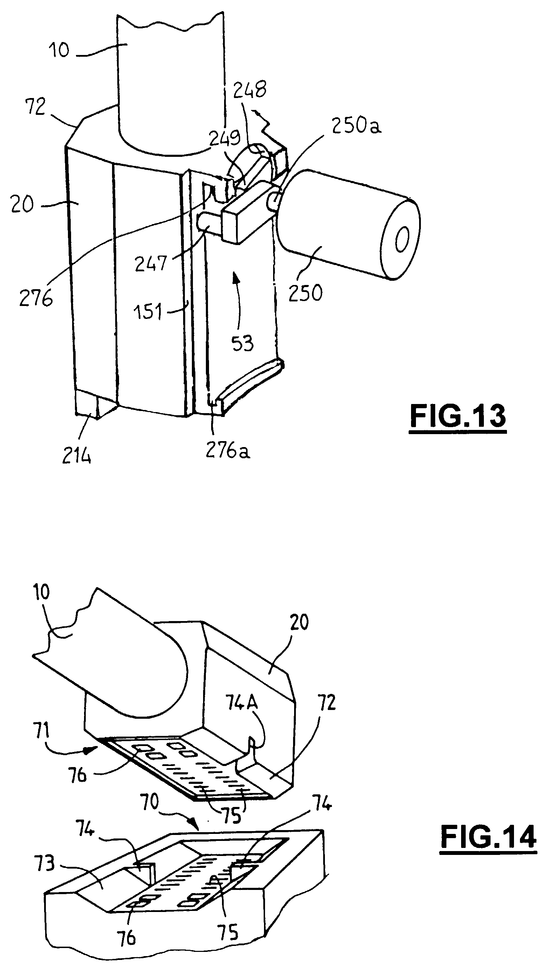

La figure 12 montre un processus d'échange de cartouche selon l'invention, montrant une cartouche à traiter dans sa position de travail 11 alignée avec l'axe 23 du four 1.

Le barillet 9 ou plateau tournant porte un ensemble de par exemple 6 à 32 pieds de cartouche 20 dans lesquels sont engagées de façon amovible les cartouches 10 contenant des échantillons à traiter. Les cartouches 10 sont montées sur les pieds de cartouche 20 par des moyens de liaison classiques, par exemple à soudure, non représentés sur le dessin. La liaison entre une cartouche 10 et son pied de support 20 comprend en outre des passages électriques pour permettre une liaison avec les capteurs de mesure incorporés à la cartouche.

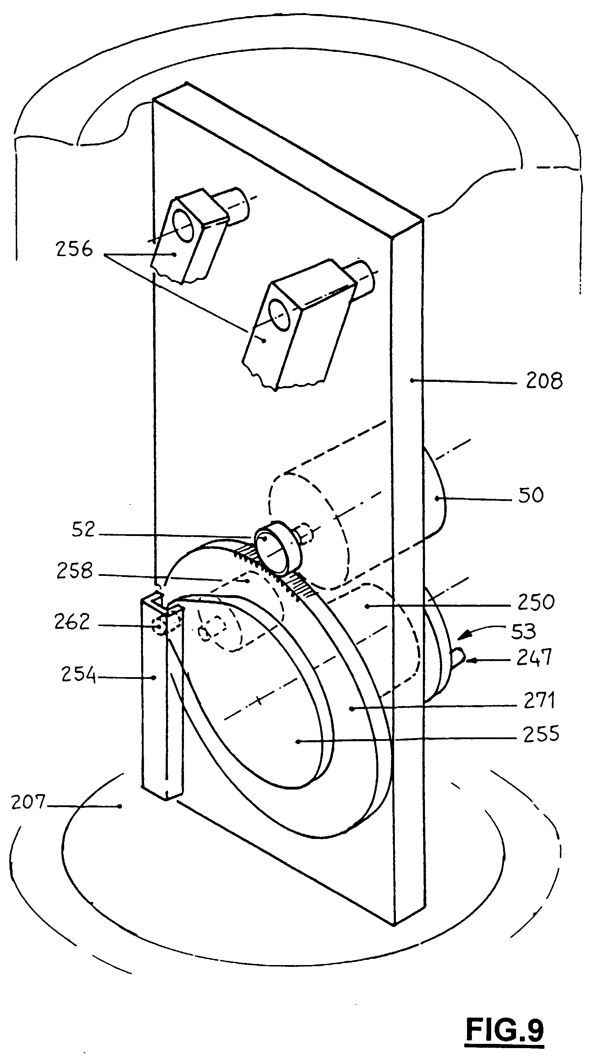

Un moteur électrique unique 50 (qui sera décrit plus loin en référence à la figure 9) commande l'entraînement du mécanisme de mise en rotation du barillet 9. Lorsqu'une cartouche à traiter stockée dans le barillet 9 arrive à proximité du plan défini par l'axe de rotation 22 du barillet 9 et l'axe longitudinal 23 du four 1, le mécanisme de mise en rotation du barillet 9, auquel sont associés des moyens de transfert de cartouche, provoque automatiquement la translation du pied 21 de la cartouche à traiter 11 pour amener celle-ci dans la position de traitement représentée en pointillés sur la figure 12, l'axe de la cartouche étant confondu avec l'axe 23 du four 1.

L'exactitude du positionnement peut être définie par des surfaces ajustées, telles que des portions complémentaires en vé, disposées respectivement sur le pied 21 de la cartouche à traiter et sur l'extrémité 17 du support 6 sur lequel est monté le mécanisme de translation du four (figure 1).

Des exemples de mécanisme de commande de rotation du barillet 9 et de translation des pieds de cartouche 20 seront donnés plus loin dans la description.

Lorsqu'une cartouche 11 est en position de traitement, un connecteur électrique placé sur le pied de cartouche 21 est automatiquement mis en contact avec un connecteur électrique correspondant placé sur l'extrémité 17 du support 6. Toutefois, à titre de variante, il est également possible d'associer à chaque cartouche un câble souple relié à un contacteur tournant ayant même axe que le barillet 9 et coopérant avec le connecteur électrique placé sur l'extrémité 17 du support 6.

La figure 12 montre un mode particulier de réalisation dans lequel le barillet 9 est enfermé dans un compartiment hermétique 24 contenant l'ensemble des pieds de cartouche 20 et des cartouches 10. Une ouverture latérale oblongue 25, dont la ligne médiane correspond au plan défini par l'axe de rotation du barillet et l'axe 23 du four, permet le passage d'une cartouche à traiter 11 en position de travail. L'ouverture 25 est fermée sélectivement par un volet mobile 27 portant sur la surface d'étanchéité 26 entourant l'ouverture 25. Lors du transport, le volet 27 est fermé et empêche que des produits toxiques contenus dans des cartouches ne se répandent à l'extérieur en cas d'incident. Lorsque le barillet 9 est chargé dans la chambre de process 2 (figures 1 et 2), le volet 27 est ouvert pour permettre la sortie des cartouches. L'étanchéité entre la chambre de process et le barillet 9 est obtenue par une bride 29 portant par exemple un joint torique 28. Le volet 27 peut opérer par coulissement ou par pivotement.

Lorsqu'une cartouche à traiter 11 est translatée par action du mécanisme de transfert sur le pied de cartouche 21, le four 1 est dans la position reculée représentée en pointillé sur la figure 2. Le mécanisme de translation du four, qui peut lui-même être classique, provoque une première course a qui permet d'enfourner partiellement dans le four 1 la cartouche à traiter 11 (position 1'). Cette course a peut être typiquement de 100 à 200 mm. Dans le cas d'un traitement correspondant à la solidification orientée d'un échantillon, le four 1 est chauffé pour provoquer le début de la fusion du matériau contenu dans la cartouche 11. Le four 1 descend alors selon la course s, qui peut être par exemple de l'ordre de 100 à 200 mm, jusqu'à la position 1" représentée en traits pleins sur la figure 2, ce qui entraîne la fusion du matériau à fondre. Le four remonte ensuite de sa position 1" à la position 1' en traits discontinus définie par la course s, ce qui entraîne la solidification orientée du matériau. Le four est ensuite refroidi et ramené à la position 1 en pointillés de la figure 2 avec la course supplémentaire a permettant le retrait de la cartouche 11 qui est ramenée dans le barillet par translation du pied de cartouche 21. Après une nouvelle rotation partielle du barillet 9 amenant une autre cartouche 10 au voisinage du plan défini par les axes 22 et 23, le processus de translation et traitement peut recommencer avec cette autre cartouche.

On notera que, dans le cas d'un four spatial, tous les différents mouvements des cartouches et du four sont très lents et ont ainsi de très faibles répercussions sur l'attitude du véhicule spatial dans lequel est embarqué le four. La lenteur des mouvements en apesanteur, ajoutée au fait que les centres de gravité des organes du dispositif d'échange de cartouche se déplacent très peu, permet de réduire les contraintes auxquelles sont soumis les organes mécaniques, ce qui, outre l'accroissement de fiabilité, permet de réduire la masse de ces différents organes et de la source d'énergie commandant le mécanisme et par suite d'effectuer une économie sur l'opération de mise en orbite. En outre, la perturbation de la micro-gravité est très faible.

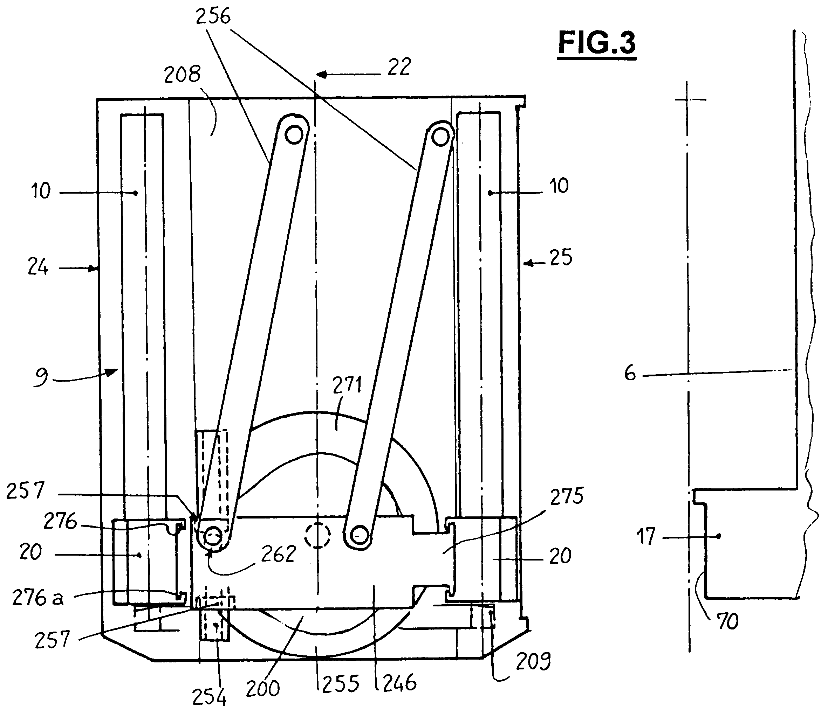

On décrira maintenant en référence aux figures 3 à 10 un premier mode de réalisation d'un dispositif de chargement de four conforme à l'invention, dans lequel chaque pied de cartouche 20 du barillet 9 coopère avec un mécanisme de transfert 200 comportant un bras de translation 246 perpendiculaire à l'axe de rotation 22 du barillet et situé dans le plan défini par l'axe de rotation 22 du barillet et l'axe du four 23, de façon à permettre à chaque cartouche 10 de venir successivement prendre une position de travail 11 dans laquelle l'axe de la cartouche est aligné avec l'axe géométrique 23 du four 1. Selon l'invention, le mécanisme 12 de commande d'entraînement en rotation des pieds de cartouche 20 et le mécanisme de transfert 200 coopèrent entre eux et sont activés en alternance à partir d'un moteur électrique unique 50 (figure 9).

Comme on peut le voir sur les figures 3, 4 et 9, le mécanisme de transfert 200 comprend au moins deux bras 256 qui sont articulés à leur extrémité supérieure sur une console verticale 208 fixée sur le fond 207 du barillet 9, perpendiculairement à ce fond 207, et de préférence fixée également au couvercle du logement du barillet afin de mieux rigidifier l'ensemble. Les bras 256 sont par ailleurs articulés à leur partie inférieure sur le bras de translation 246 afin de constituer avec ce bras de translation 246 une structure en parallélogramme.

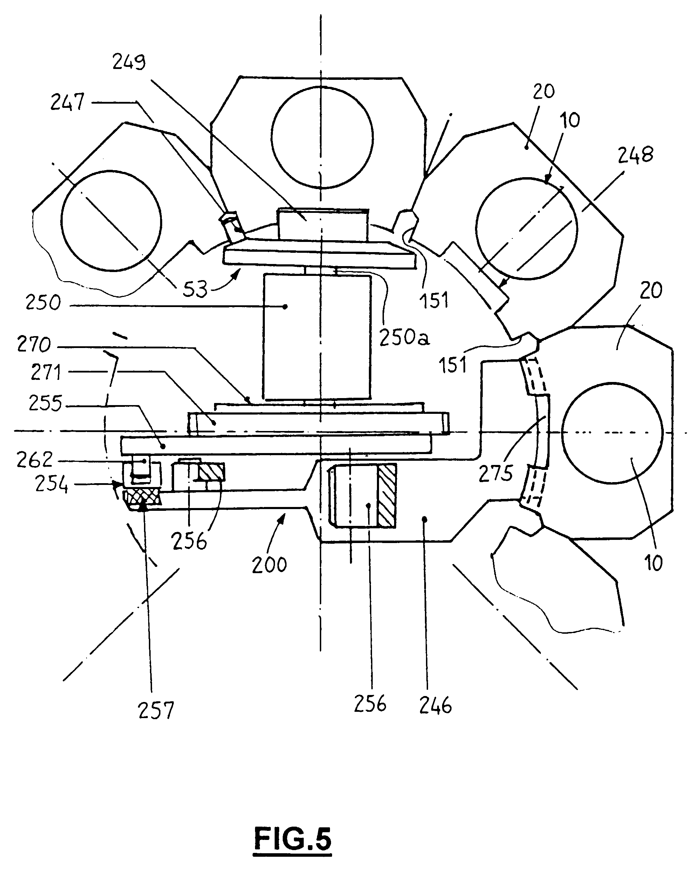

Le mécanisme 12 de commande d'entraînement en rotation des pieds de cartouche comprend un axe 250a qui est disposé perpendiculairement au bras de translation 246, reçoit à l'une de ses extrémités un mouvement de rotation initié par le moteur électrique 50 et entraîne à son autre extrémité un dispositif à croix de Malte 53 agissant sur les pieds de cartouche 20 (figures 5,6 et 9). L'axe 250a est monté dans un palier 250.

De façon plus particulière, comme on peut le voir sur les figures 5,6,9 et 13, le dispositif à croix de Malte 53 comprend un doigt 247 de commande de rotation agissant sur des gorges 151 formées dans les pieds de cartouche 20 parallèlement à l'axe 22 du barillet et une came 249 coopérant avec des alvéoles 248 formées dans les pieds de cartouche 20 pour assurer un verrouillage à chaque indexation.

Le moteur électrique 50 est de préférence disposé de façon horizontale et coopère avec un pignon réducteur 52 comme représenté sur la figure 9.

Selon le mode de réalisation représenté notamment sur les figures 3 à 6 et 9, le mécanisme de transfert 200 comprend un guide 254 qui est fixé sur le bras de translation 246 perpendiculairement à celui-ci et parallèlement à l'axe de rotation 22 du barillet 9. Un doigt 262 qui est solidaire d'un plateau 255 dont le plan est parallèle à la console 208, est engagé dans le guide 254.

Le plateau 255 peut être entraîné sélectivement à travers un dispositif d'embrayage 258 à partir d'une roue dentée d'entraînement 271 qui est disposée parallèlement à l'une des faces principales de la console 208. La roue dentée 271 est en prise avec le pignon réducteur 52 disposé en sortie du moteur électrique 50.

Un disque 270 dont le plan est parallèle aux faces principales de la console 208 et qui est solidaire de l'axe 205a auquel est rattaché le dispositif à croix de Malte 53 peut être entraîné sélectivement à travers le dispositif d'embrayage 258 à partir de la roue dentée 271 lorsque le plateau 255 du mécanisme de transfert 200 est lui-même débrayé par rapport à la roue dentée d'entraînement 271.

Des éléments élastiques 257 sont interposés entre le guide 254 et le bras de translation 246 afin d'éviter de former un système hyperstatique.

D'une manière générale, le palier 250 et l'axe 250a d'entraînement du dispositif à croix de Malte 53 sont disposés essentiellement perpendiculairement au bras de translation 246 et au plan contenant l'axe du four 23 et l'axe de rotation 22 du barillet, dans un cas où le barillet comprend un nombre de cartouches multiple de 4.

Sur les figures 3 et 5, le barillet 9 est représenté en position de repos, un pied de cartouche 20 étant situé dans le plan des axes 22, 23 et en prise avec l'extrémité libre du bras 246 situé face au four.

Comme on peut le voir sur les figures 3 à 6 et 8, le bras de translation 246 présente des parties saillantes 275 pouvant venir se loger dans des gorges de profil complémentaire 276 formées dans les pieds de cartouche 20 lorsqu'un pied de cartouche 20 est positionné en face du bras de translation 246.

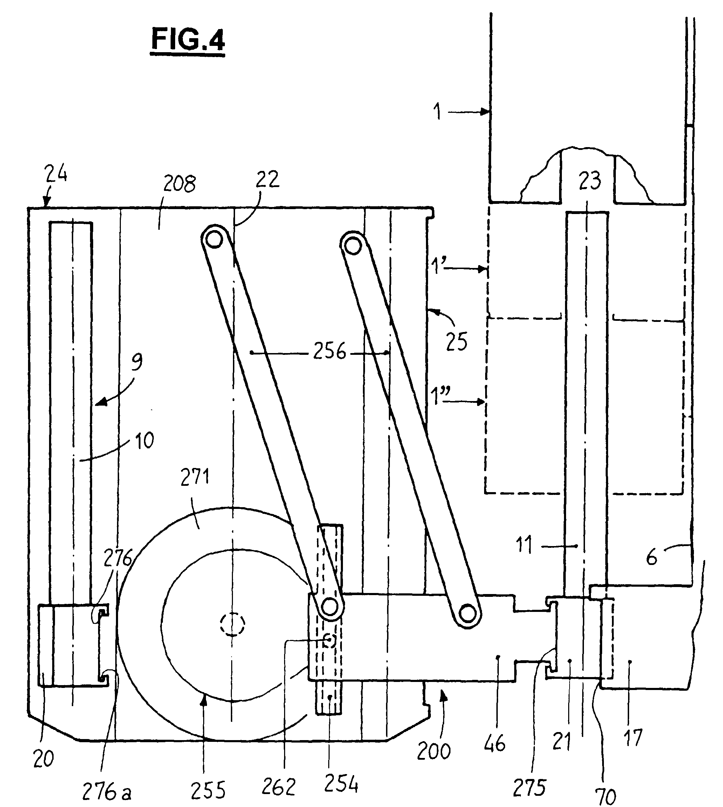

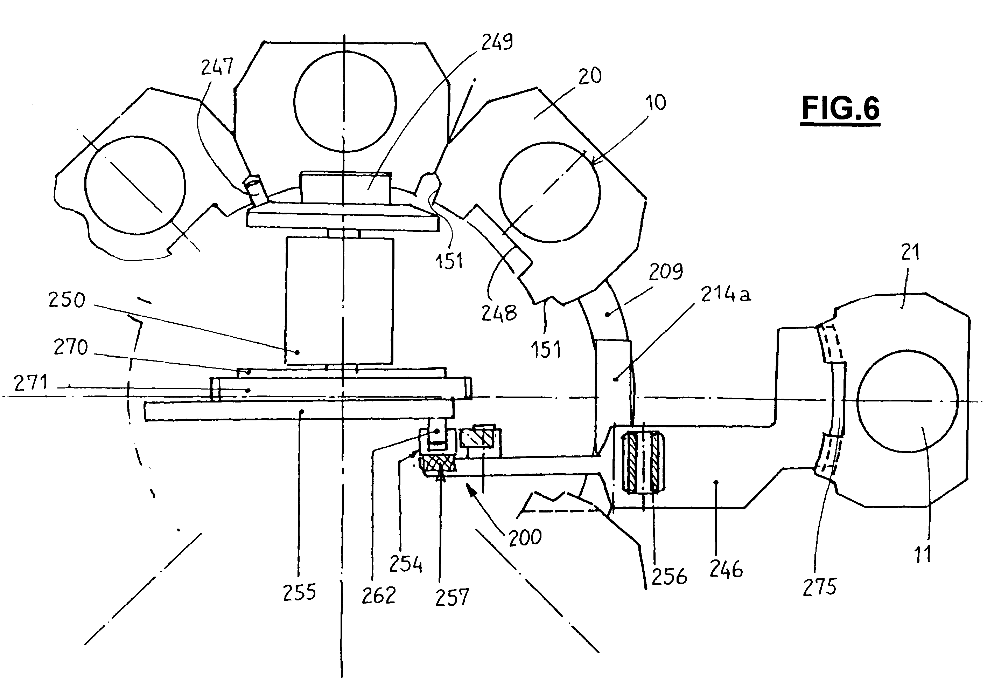

Dans une phase de transfert (passage de la position des figures 3 et 5 à celle des figures 4 et 6), un pied de cartouche 20 est entrainé en translation par le bras mobile 246 lui-même activé par le guide 254 entraîné par le doigt 262 solidaire du plateau 255.

Le mouvement de translation est guidé par les bras 256.

Les figures 4 et 6 représentent une cartouche 11 en position de travail. Le pied de cartouche 21 est appliqué contre le support fixe 17 solidaire du mécanisme de translation du four 6.

Le four passe alors de la position de chargement à la position de début de chauffe 1' puis à la position de fin de fusion 1".

Pour amener la cartouche 10 de la position de stockage à une position de travail 11, le plateau 255 a effectué une rotation sensiblement égale à un demi-tour, pendant que le mécanisme de commande d'entraînement en rotation des pieds de cartouche est lui-même resté immobile.

On peut noter que la position finale de la cartouche 11 est peu sensible à une éventuelle erreur de rotation du plateau.

Les figures 5 et 6 représentant le barillet vu de dessus montrent la relation entre le mécanisme 12 de commande d'entraînement en rotation des pieds de cartouche et le mécanisme 200 de transfert de cartouche, qui sont décalés de 90° l'un de l'autre, mais présentent des actuateurs coaxiaux entraînés à partir du moteur électrique unique 50 et constituant un dispositif d'embrayage 258.

Le dispositif d'embrayage 258 permet d'entraîner alternativement le disque 270 ou le plateau 255 à partir du moteur 50, du pignon réducteur 52 et de la roue dentée 271.

Sur la figure 6, on voit la cartouche 11 positionnée selon l'axe du four, la roue dentée 271 et le plateau 255 ayant effectué un demi-tour tandis que le disque 270 est resté immobile.

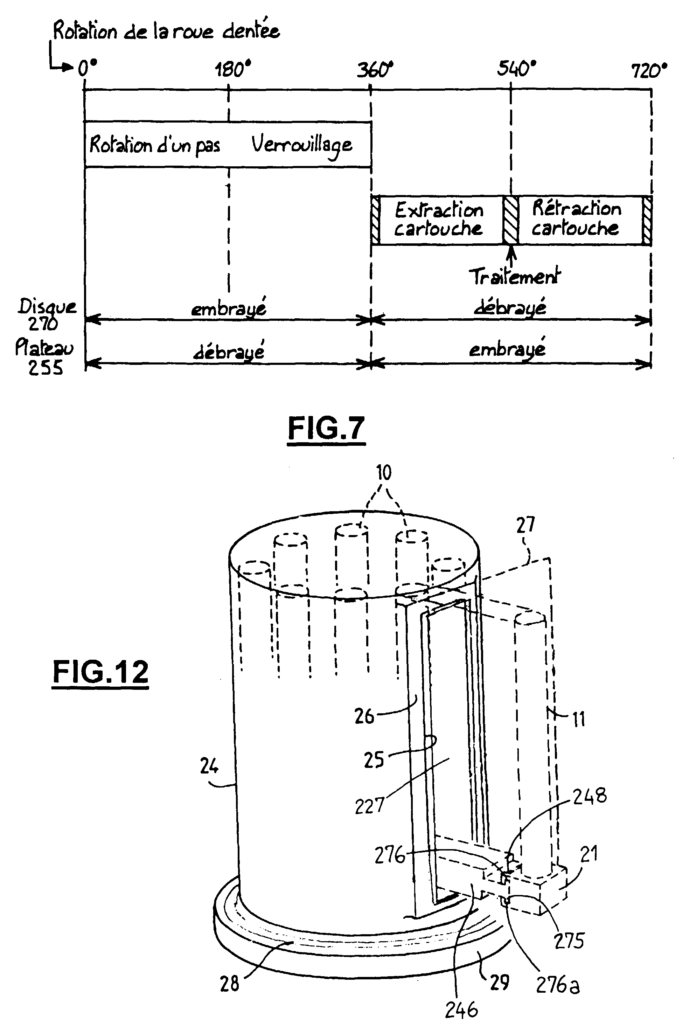

Le diagramme opératoire d'un cycle complet d'extraction-rétraction d'une cartouche réparti sur deux rotations de la roue dentée 271 est représenté sur la figure 7.

Ce cycle complet est le suivant : lors d'une rotation de deux tours de la roue dentée 271 entraînée par le moteur électrique 50, lors du premier tour correspondant à une rotation d'un pas du barillet et au verrouillage des pieds de cartouche 20, le disque 270 solidaire de l'axe 250a auquel est rattaché le dispositif à croix de Malte 53 est embrayé sur la roue dentée d'entraînement 271 pendant que le plateau 255 du mécanisme de transfert est débrayé de la roue dentée d'entraînement 271, et lors du deuxième tour correspondant à une étape d'extraction d'une cartouche 11 du barillet 9, de traitement de la cartouche extraite 11 dans le four et de remise en place de la cartouche, le disque 270 solidaire de l'axe 250a auquel est rattaché le dispositif à croix de Malte 53 est débrayé de la roue dentée d'entraînement 271 tandis que le plateau 255 du mécanisme de transfert est embrayé sur la roue dentée d'entraînement 271.

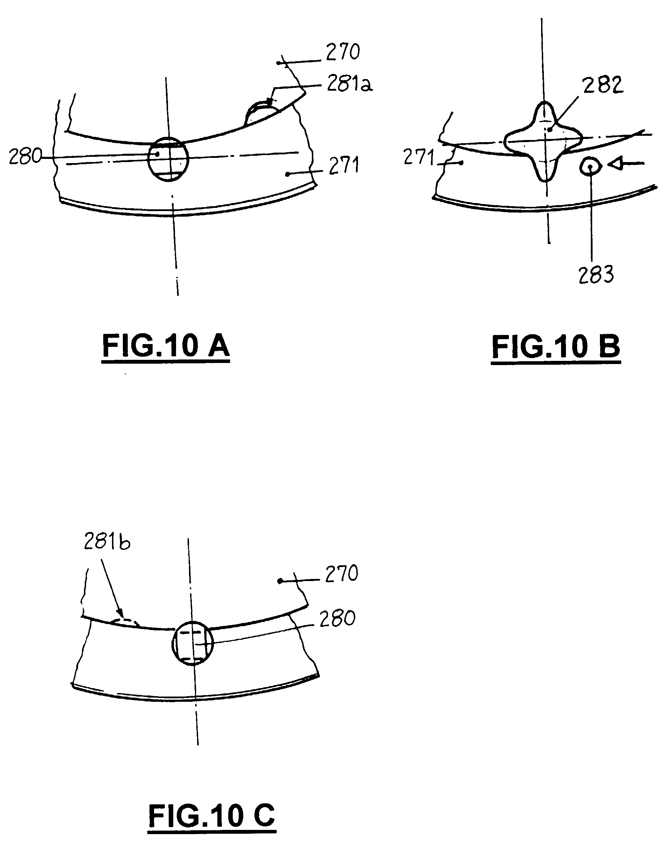

L'actuateur 258 permettant d'embrayer alternativement le plateau 255 ou le disque 270 sur la roue 271 peut être actif et constitué par un électroaimant bistable ou de type passif comme représenté sur les figures 10A, 10B et 10C.

L'actuateur passif 280 tourillonne dans la roue 271, est muni de quatre faces plates disposées en deux paires de faces opposées et se trouve verrouillé alternativement sur une empreinte 281a taillée dans le disque 270 et dans une empreinte 281b taillée dans le plateau 255. Une molette 282 en forme de croix présente quatre positions stables. Sous l'effet d'un doigt 283, pour chaque tour de la roue 271, la molette 282 subit une rotation de 90° qui provoque le verrouillage alternatif mentionné précédemment.

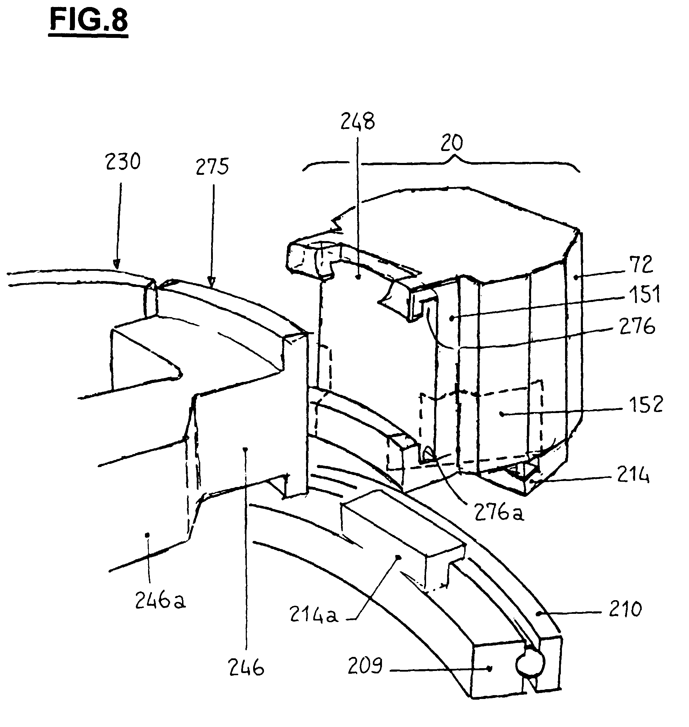

La figure 8 montre le détail de l'interface entre le bras de translation 246 et un pied de cartouche 20.

On distingue sur le pied de cartouche 20 les gorges 276, 276a recevant les parties saillantes 275 du bras de translation 246, la fente 151 complémentaire du doigt d'entraînement 247 de la croix de Malte, une face 72 de centrage sur le mécanisme du four, un évidement optionnel 152 pour permettre le passage d'une éventuelle excroissance 246a du bras 246, une alvéole 248 permettant le verrouillage par la croix de Malte et un talon 214 de montage du pied de cartouche 20 sur un ergot 214a solidaire de la base 209 du barillet. Une bague fixe du roulement intégré au barillet est repérée 210.

On voit également sur la figure 8 un anneau de sécurité fixe optionnel 230 qui permet d'empêcher le dégagement des pieds de cartouche 20 des ergots 214a en dehors de la position située dans l'alignement du bras 246.

La figure 14 montre un exemple de connecteur électrique plat 71 formé sur un pied de cartouche 20 et coopérant avec un connecteur 70 formé sur le support 6 du mécanisme de translation du four.

Chacun des connecteurs 71, 70 comprend des éléments de centrage latéral complémentaires en vé 72 respectivement 73, au moins un élément de centrage axial 74 respectivement 74A, des contacts électriques de faible intensité 75 et des contacts électriques de plus forte intensité 76. Les connecteurs électriques 70, 71 ne sont engagés l'un avec l'autre que lorsque le pied de cartouche 20 est placé en position de travail. Les contacts 75, 76 peuvent être réalisés par exemple par des surfaces métallisées sur circuit imprimé pour le connecteur 71 et par des cils flexibles pour le connecteur 70.

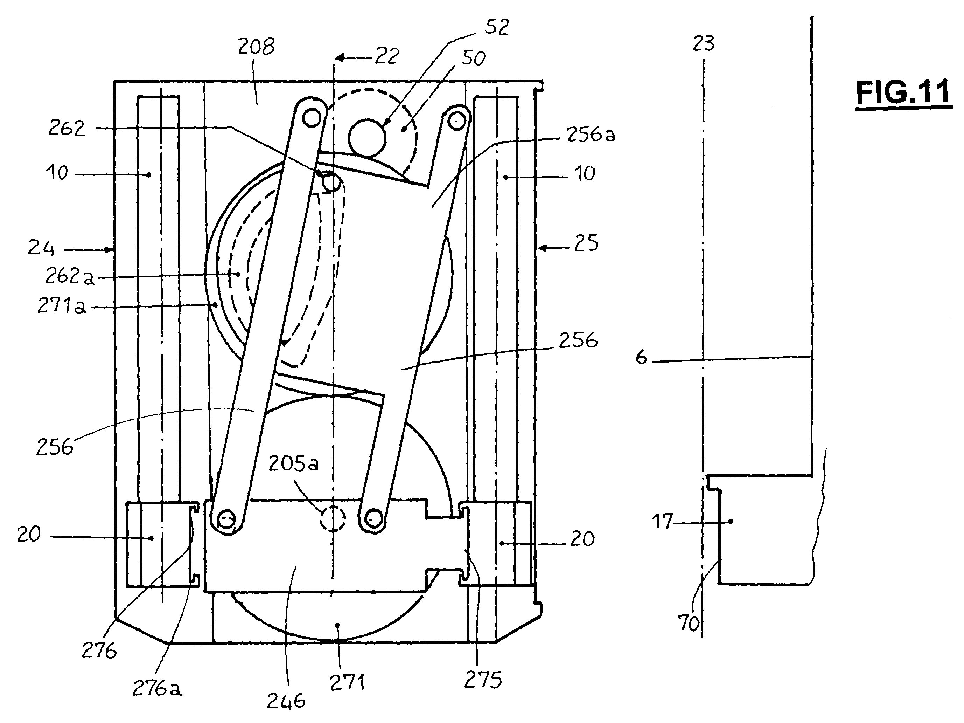

La figure 11 montre un deuxième mode de réalisation d'un dispositif de chargement de four conforme à l'invention.

Le mode de réalisation de la figure 11 présente une structure plus simple que celle du premier mode de réalisation mais n'autorise pas un traitement dans un ordre aléatoire avec la possibilité de choisir arbitrairement sur le barillet la cartouche devant être traitée.

Le mode de réalisation de la figure 11 met en oeuvre un mécanisme n'utilisant qu'un quart de rotation d'une première roue dentée d'entraînement 271a du moteur électrique 50 pour une phase d'extraction ou de rétraction d'une cartouche par rapport au barillet. Ce mécanisme supprime la nécessité de disposer d'un organe d'embrayage 258.

Dans le cas de la figure 11, les bras 256 et le bras de translation 246 montés en forme de parallélogramme sont conservés, de même que le moteur électrique unique 50 et le pignon réducteur 52.

En revanche, le plateau 255, le disque 270 et le guide 254 du mode de réalisation des figures 3 à 6 sont supprimés.

Une deuxième roue dentée 271 entraîne directement l'axe 250a du mécanisme à croix de Malte 53 qui peut présenter la même structure que celle décrite précédemment. La deuxième roue dentée 271 est elle-même entraînée par la première roue dentée 271a qui présente le même nombre de dents et est entraînée par le pignon réducteur 52 placé en sortie du moteur 50. La première roue dentée 271a est munie d'un doigt 262 agissant sur une came 262a solidaire d'une excroissance 256a de l'une des bras 256.

Dans le mode de réalisation de la figure 11, grâce au profil particulier de la came 262a, un cycle complet d'extraction-rétraction d'une cartouche du barillet et d'avance d'un pas du mécanisme de rotation du barillet est réalisé à chaque tour de la première roue dentée d'entraînement 271a.

De façon plus particulière lors d'une rotation d'un tour de la première roue dentée 271a, pendant le premier demi-tour, la structure en parallélogramme du mécanisme de transfert 200 est maintenue immobile en position rentrée grâce à un profil de la came 262a en demi-cercle centré sur la première roue dentée d'entraînement 271a, tandis que la rotation des première et deuxième roues dentées d'entraînement 271a, 271 détermine la rotation des pieds de cartouche d'un pas, et, pendant le deuxième demi-tour, la rotation de la deuxième roue dentée 271 verrouille le barillet 9 dans sa position acquise précédemment tandis que la rotation de la première roue dentée 271a entraînant le doigt 262

dans une partie arquée de retour de la came 262a provoque pendant la première moitié du deuxième demi-tour une avance du bras de translation 246 amenant une cartouche 11 en position de travail dans le four, et pendant la deuxième moitié du deuxième demi-tour une rétraction du bras de translation 246 ramenant la cartouche traitée 11 dans le barillet 9.

Diverses modifications et adjonctions peuvent être apportées aux modes de réalisation décrits. Ainsi, le bras de translation mobile 246 peut être équipé d'un volet de protection 227 qui vient obturer la fenêtre 25 du conteneur hermétique 24 dans lequel est placé le barillet 9, au cours du traitement d'une cartouche 11 placée dans le four 1 (figure 12).

Le volet de protection 227 peut assurer une protection à la fois contre le rayonnement thermique du four et de la cartouche et contre une éventuelle contamination provenant d'une défaillance du creuset et de la cartouche.

## Revendications

1. Dispositif de chargement d'un four spatial automatique de traitement (1) comportant un axe géométrique longitudinal (23) et des moyens (6) pour entraîner en translation de façon guidée le four (1) le long dudit axe géométrique longitudinal (23), le dispositif de chargement étant disposé au voisinage du four (1) et comprenant un barillet (9) porte-cartouches dont l'axe de rotation (22) est parallèle à l'axe géométrique (23) longitudinal du four (1) et qui est muni d'un ensemble de pieds de cartouche (20) dans lesquels sont montées de façon amovible des cartouches (10) fermées étanches destinées à contenir chacune un échantillon à traiter dans ledit four spatial (1) et disposées dans le barillet (9) parallèlement à l'axe de rotation (22) de celui-ci, un mécanisme (12) de commande d'entraînement en rotation des pieds de cartouche avec indexation et un mécanisme de transfert (200) coopérant avec chaque pied de cartouche (20) du barillet (9) pour permettre à chaque cartouche de venir successivement prendre une position de travail (11) dans laquelle l'axe de la cartouche est aligné avec l'axe géométrique (23) du four (1), caractérisé en ce que le barillet (9) est lui-même monté latéralement par rapport au four (1), en ce que le mécanisme de transfert (200) comporte un bras de translation (246) perpendiculaire à l'axe de rotation (22) du barillet (9), en ce que le mécanisme (12) de commande d'entraînement en rotation des pieds de cartouche et le mécanisme de transfert (200) sont activés en alternance à partir d'un moteur électrique unique (50) et en ce que le moteur électrique unique (50), le mécanisme (12) de commande d'entraînement en rotation des pieds de cartouche et le mécanisme de transfert (200) sont disposés dans l'espace central libre du barillet (9) porte-cartouches.

2. Dispositif selon la revendication 1, caractérisé en ce que le barillet (9) ainsi que les mécanismes (12, 200) de commande d'entraînement en rotation des pieds de cartouche et de transfert sont placés à l'intérieur d'un conteneur hermétique (24) muni d'une ouverture latérale obturable (25).

3. Dispositif selon la revendication 1 ou la revendication 2, caractérisé en ce que le mécanisme (12) de commande d'entraînement en rotation des pieds de cartouche comprend un axe (250a) qui est disposé perpendiculairement au bras de translation (246), reçoit à l'une de ses extrémités un mouvement de rotation initié par le moteur électrique (50) et entraîne à son autre extrémité un dispositif à croix de Malte (53) agissant sur les pieds de cartouche (20).

4. Dispositif selon la revendication 3, caractérisé en ce que le mécanisme à croix de Malte (53) comprend un doigt (247) de commande de rotation agissant sur des gorges (151) formées dans les pieds de cartouche (20) parallèlement à l'axe (22) du barillet et une came (249) coopérant avec des alvéoles (248) formées dans les pieds de cartouche (20) pour assurer un verrouillage à chaque indexation.

5. Dispositif selon l'une quelconque des revendications 1 à 4, caractérisé en ce que le mécanisme de transfert (200) comprend au moint deux bras (256) articulés d'une part sur une console (208) fixée sur le fond (207) du barillet (9) perpendiculairement à ce fond (207) et d'autre part sur le bras de translation (246) pour constituer avec le bras de translation (246) une structure en parallélogramme.

6. Dispositif selon la revendication 5, caractérisé en ce que le mécanisme de transfert (200) comprend un guide (254) fixé sur le bras de translation (246) perpendiculairement à celui-ci, un doigt (262) engagé dans le guide (254) et solidaire d'un plateau (255) dont le plan est parallèle à ladite console (208) et qui peut être entraîné sélectivement à travers un dispositif d'embrayage (258) à partir d'une roue dentée d'entraînement (271) dont l'axe est perpendiculaire au plan de la console (208) et qui est en prise avec un pignon réducteur (52) disposé en sortie du moteur électrique (50).

7. Dispositif selon la revendication 3 et la revendication 6, caractérisé en ce que le mécanisme (12) de commande d'entraînement en rotation des pieds de cartouche comprend un disque (270) dont le plan est parallèle à la console (208), qui est solidaire de l'axe (250a) auquel est rattaché le dispositif à croix de Malte (53) et qui peut être entraîné sélectivement à travers le dispositif d'embrayage (258) à partir de la roue dentée d'entraînement (271) lorsque le plateau (255) du mécanisme de transfert (200) est lui-même débrayé par rapport à la roue dentée d'entraînement (271).

8. Dispositif selon l'une quelconque des revendications 6 et 7, caractérisé en ce que des éléments élastiques (257) sont interposés entre le guide (254) et le bras de translation (246).

9. Dispositif selon la revendication 7, caractérisé en ce que lors d'une rotation de deux tours de la roue dentée d'entraînement (271), lors du premier tour correspondant à une rotation d'un pas du barillet et au verrouillage des pieds de cartouche (20), le disque (270) solidaire de l'axe (250a) auquel est rattaché le dispositif à croix de Malte (53) est embrayé sur la roue dentée d'entraînement (271) pendant que le plateau (255) du mécanisme de transfert est débrayé de la roue dentée d'entraînement (271), et lors du deuxième tour correspondant à une étape d'extraction d'une cartouche (11) du barillet (9), de traitement de la cartouche extraite (11) dans le four et de remise en place de la cartouche, le disque (270) solidaire de l'axe (250a) auquel est rattaché le dispositif à croix de Malte (53) est débrayé de la roue dentée d'entraînement (271) tandis que le plateau (255) du mécanisme de transfert est embrayé sur la roue dentée d'entraînement(271).

10. Dispositif selon la revendication 5, caractérisé en ce que le mécanisme de transfert (200) comprend une came (262a) solidaire de l'un des bras (256), et un doigt (262) qui agit sur la came (262a) et est solidaire d'une première roue dentée d'entraînement (271a) dont l'axe est prependiculaire au plan de la console (208) et qui est en prise avec un pignon réducteur (52) disposé en sortie du moteur électrique (50).

11. Dispositif selon la revendication 3 et la revendication 10, caractérisé en ce que le mécanisme (12) de commande d'entraînement en rotation des pieds de cartouche comprend une deuxième roue dentée d'entraînement (271) dont l'axe est perpendiculaire au plan de la console (208), qui présente le même nombre de dents que la première roue dentée d'entraînement (271a) et qui est en prise avec cette dernière, la deuxième roue dentée d'entraînement (271) étant solidaire de l'axe (250a) auquel est rattaché le dispositif à croix de Malte (53).

12. Dispositif selon la revendication 11, caractérisé en ce que lors d'une rotation d'un tour de la première roue dentée d'entraînement (271a), pendant le premier demi-tour, la structure en parallélogramme du mécanisme de transfert (200) est maintenue immobile en position rentrée grâce à un profil de la came

(262a) en demi-cercle centré sur la première roue dentée d'entraînement (271a), tandis que la rotation des première et deuxième roues dentées d'entraînement (271a, 271) détermine la rotation des pieds de cartouche d'un pas, et, pendant le deuxième demi-tour, la rotation de la deuxième roue dentée (271) verrouille le barillet (9) dans sa position acquise précédemment tandis que la rotation de la première roue dentée (271a) entraînant le doigt (262) dans une partie arquée de retour de la came (262a) provoque pendant la première moitié du deuxième demi-tour une avance du bras de translation (246) amenant une cartouche (11) en position de travail dans le four, et pendant la deuxième moitié du deuxième demi-tour une rétraction du bras de translation (246) ramenant la cartouche traitée (11) dans le barillet (9).

13. Dispositif selon l'une quelconque des revendications 1 à 12, caractérisé en ce que le bras de translation (246) présente des parties saillantes (275) pouvant venir se loger dans des gorges de profil complémentaire (276) formées dans les pieds de cartouche (20), lorsqu'un pied de cartouche (20) est positionné en face du bras de translation (246).

14. Dispositif selon la revendication 6, caractérisé en ce que le dispositif d'embrayage est de type actif et comprend un électro-aimant.

15. Dispositif selon la revendication 7, caractérisé en ce que le dispositif d'embrayage (258) est de type passif et comprend un élément actuateur (280) muni de deux paires de faces planes opposées, qui tourillonne dans la roue dentée d'entraînement (271) et coopère avec une molette (282) en forme de croix qui possède quatre positions stables et subit à chaque tour de la roue dentée d'entraînement (271) sous l'effet d'un doigt (283) une rotation de 90° qui a pour effet de verrouiller l'élément actuateur (280) soit dans une empreinte (281a) taillée dans le disque (270) soit dans une empreinte (281b) taillée dans le plateau (255).

16. Dispositif selon l'une quelconque des revendications 1 à 5, caractérisé en ce que chaque pied de cartouche (20) comprend une interface (71) essentiellement plane de positionnement mécanique et de connexion électrique adaptée pour coopérer avec une interface complémentaire unique (70) essentiellement plane de positionnement mécanique et de connexion électrique disposée sur des moyens de support des moyens (6) d'entraînement en translation du four (1).

17. Dispositif selon l'une quelconque des revendications 1 à 16, caractérisé en ce qu'il est appliqué à un four (1) divisé en des premier et deuxième blocs (1a, 1b) montés indépendamment par des éléments de liaison (101a, 101b) sur un support de four (6) présentant un axe (106) parallèle à l'axe (23) du four (1") en position de travail, le second bloc de four (1b) le plus éloigné du pied (21) de la cartouche traitée (11) étant monté de manière à pouvoir pivoter autour de l'axe (106) parallèle à l'axe (23) du four lorsque ce bloc est dans une position ne contenant plus de cartouche (11) et le premier bloc de four (1a) le plus proche du pied (21) de la cartouche traitée (11) étant monté de manière à pouvoir poursuivre son déplacement selon l'axe (23) du four (1) lorsque le second bloc de four (1b) a été escamoté par pivotement pour venir se positionner à côté dudit second bloc de four escamoté (1b).

**Patentansprüche**

1. Vorrichtung zum Beschicken eines automatischen Ofens zur Verarbeitung (1) im Weltraum, welcher eine geometrische Längsachse (23) und Einrichtungen (6) für den geführten Antrieb des Ofens (1) entlang der geometrischen Längsachse (23) aufweist, wobei die Beschickungsvorrichtung in der Nähe des Ofens (1) angeordnet ist und eine Patronen aufnehmende Trommel (9) aufweist, deren Drehachse (22) parallel zur geometrischen Längsachse (23) des Ofens (1) verläuft und welche eine Anordnung von Patronenunterteilen (20) aufweist, in welchen geschlossene dichte Patronen (10) lösbar angebracht sind, die jeweils zur Aufnahme einer in dem Weltraumofen (1) zu bearbeitenden Probe bestimmt und in der Trommel (9) parallel zu deren Drehachse (22) angeordnet sind, wobei eine Steuermechanik (12) für den Drehantrieb der Patronenunterteile mit Weiterschaltung und eine Transportmechanik (200) mit jedem Patronenunterteil (20) der Trommel so zusammenwirken, daß alle Patronen jeweils nacheinander eine Arbeitsstellung (11) einnehmen können, in welcher die Achse der Patrone mit der geometrischen Achse (23) des Ofens (1) fluchtet, dadurch gekennzeichnet, daß die Trommel (9) ihrerseits, bezogen auf den Ofen (1) seitlich angebracht ist, daß die Transportmechanik (200) einen zur Drehachse (22) der Trommel (9) senkrecht stehenden Verschiebearm (246) aufweist, daß die Steuermechanik (12) für den Drehantrieb der Patronenunterteile und die Transportmechanik (200) abwechselnd von einem einzigen Elektromotor (50) aktiviert werden, und daß der einzige Elektromotor (50), die Steuermechanik (12) für den Drehantrieb der Patronenunterteile und die Transportmechanik (200) im freien Raum in der Mitte der die Patronen aufnehmenden Trommel (9) angeordnet sind.

2. Vorrichtung nach Anspruch 1, dadurch gekennzeichnet, daß die Trommel (9) sowie die Steuermechaniken (12, 200) für den Drehantrieb der Patronenunterteile und für den Transport im Inneren eines hermetisch abgeschlossenen Behälters (24) eingesetzt sind, welcher eine verschließbare seitliche Öffnung (25) aufweist.

3. Vorrichtung nach Anspruch 1 oder Anspruch 2, dadurch gekennzeichnet, daß die Steuermechanik (12) für den Drehantrieb der Patronenunterteile eine Achse (250a) aufweist, die senkrecht zu dem Verschiebearm (246) angeordnet ist, an einem ihrer Enden eine vom Elektromotor (50) veranlaßte Drehbewegung übernimmt, und an ihrem anderen Ende eine Vorrichtung (53) mit Sternradgetriebe antreibt, welche auf die Patronenunterteile (20) einwirkt.

4. Vorrichtung nach Anspruch 3, dadurch gekennzeichnet, daß die Mechanik mit Sternradgetriebe (53) einen Betätigungsfinger (247) für die Drehsteuerung aufweist, der auf Auskehlungen (151) einwirkt, welche in den Patronenunterteilen (20) parallel zur Achse (22) der Trommel ausgebildet sind, sowie einen Nocken (249), welcher mit Ausnehmungen (248) zusammenwirkt, die in den Patronenunterteilen (20) ausgeformt sind und eine Verriegelung bei jeder Positionierung gewährleisten.

5. Vorrichtung nach einem der Ansprüche 1 bis 4, dadurch gekennzeichnet, daß die Transportmechanik (200) mindestens zwei Arme (256) aufweist, welche zum einen auf einer fest auf dem Boden (207) der Trommel (9) senkrecht zu diesem angebrachten Konsole und zum anderen auf dem Verschiebearm (246) in der Weise angelenkt sind, daß mit dem Verschiebearm (246) eine Konstruktion in Form eines Parallelogramms entsteht.

6. Vorrichtung nach Anspruch 5, dadurch gekennzeichnet, daß die Transportmechanik (200) eine auf dem Verschiebearm (246) senkrecht zu diesem befestigte Führung (254) sowie einen in die Führung (254) eingreifenden und fest mit einer Platte (255) verbundenen Finger aufweist, deren Ebene parallel zu der Konsole (208) verläuft und welche selektiv über eine Einrückvorrichtung (258) von einem Antriebszahnrad (271) aus antreibbar ist, dessen Achse senkrecht zur Ebene der Konsole (208) verläuft und welches mit einem Untersetzungsritzel (52) kämmt, das auf der Abtriebsseite des Elektromotors (50) angeordnet ist.

7. Vorrichtung nach Anspruch 3 und Anspruch 6, dadurch gekennzeichnet, daß die Steuermechanik (12) für den Drehantrieb der Patronenunterteile eine Scheibe (270) aufweist, deren Ebene parallel zu der Konsole (208) verläuft, die fest mit der Achse (250a) verbunden ist, an welche die Vorrichtung mit Sternradgetriebe (53) angesetzt ist, und die selektiv über die Einrückvorrichtung (258) von dem Antriebszahnrad (271) aus antreibbar ist, wenn die Platte (255) der Transportmechanik (200) ihrerseits gegenüber dem Antriebszahnrad (271) ausgerückt ist.

8. Vorrichtung nach einem der Ansprüche 6 und 7, dadurch gekennzeichnet, daß zwischen der Führung (254) und dem Verschiebearm (246) elastische Elemente (257) eingesetzt sind.

9. Vorrichtung nach Anspruch 7, dadurch gekennzeichnet, daß bei einer Drehung des Antriebszahnrads (271) um zwei Umdrehungen während der ersten Umdrehung, welche einer Drehung der Trommel um einen Schritt und der Verriegelung der Patronenunterteile (20) entspricht, die Scheibe (270), welche fest mit der Achse (250a) verbunden ist, an welche die Vorrichtung mit Sternradgetriebe (53) angesetzt ist, in das Antriebszahnrad (271) eingerückt wird, wohingegen die Platte (255) der Transportmechanik aus dem Antriebszahnrad (271) ausgerückt ist, und während der zweiten Umdrehung, welche einem Schritt zum Herausnehmen einer Patrone (11) aus der Trommel (9), zur Bearbeitung der herausgenommenen Patrone (11) in dem Ofen und zum Zurückstellen der Patrone entspricht, die Scheibe (270), welche fest mit der Achse (250a) verbunden ist, an welche die Vorrichtung mit Sternradgetriebe (53) angesetzt ist, aus dem Antriebszahnrad (271) ausgerückt wird, wohingegen die Platte (255) der Transportmechanik in das Antriebszahnrad (271) eingerückt wird.

10. Vorrichtung nach Anspruch 5, dadurch gekennzeichnet, daß die Transportmechanik (200) einen Nocken (262a), der fest mit einem der Arme (256) verbunden ist, sowie einen Finger (262) aufweist, der auf den Nocken (262a) einwirkt und fest mit einem ersten Antriebszahnrad (271a) verbunden ist, dessen Achse senkrecht zur Ebene der Konsole (208) verläuft und welches mit einem Untersetzungsritzel (52) kämmt, welches auf der Abtriebsseite des Elektromotors (50) angeordnet ist.

11. Vorrichtung nach Anspruch 3 und Anspruch 10, dadurch gekennzeichnet, daß die Steuermechanik (12) für den Drehantrieb der Patronenunterteile ein zweites Antriebszahnrad (271) aufweist, dessen Achse senkrecht zur Ebene der Konsole (208) verläuft und welches die gleiche Anzahl Zähne wie das erste Antriebszahnrad (271) besitzt und mit letzterem in Eingriff steht, wobei das zweite Antriebszahnrad (271) fest mit der Achse (250a) verbunden ist, an welcher die Vorrichtung mit Sternradgetriebe (53) angesetzt ist.

12. Vorrichtung nach Anspruch 11, dadurch gekennzeichnet, daß bei einer Drehung des ersten Antriebszahnrads (271a) um eine Umdrehung während der ersten halben Umdrehung die Konstruktion der Transporteinrichtung (200) in Form eines Parallelogramms wegen eines halbkreisförmigen Profils des Nockens (262a), der auf dem ersten Antriebszahnrad (271a) zentriert ist, in zurückgezogener Position unbeweglich gehalten ist, während die Drehung des ersten und zweiten Antriebszahnrads (271a, 271) die Drehung der Patronenunterteile um einen Schaltschritt bestimmt, und während der zweiten halben Umdrehung die Drehbewegung des zweiten Zahnrads (27a) die Trommel in ihrer zuvor eingenommenen Position verriegelt, während die Drehung des ersten Zahnrads (271a), das den Finger (262) in einem gebogenen Abschnitt zur Rückstellung des Nockens (262a) antreibt, während der ersten Hälfte der zweiten halben Umdrehung eine Vorwärtsbewegung des Verschiebearmes (246) herbeiführt, der eine Patrone (11) in Arbeitsstellung in den Ofen mitnimmt, und während der zweiten Hälfte der zweiten halben Umdrehung ein Zurückziehen des Verschiebearmes (246), welcher die bearbeitete Patrone (11) in die Trommel (9) zurückführt.

13. Vorrichtung nach einem der Ansprüche 1 bis 12, dadurch gekennzeichnet, daß der Verschiebearm (246) vorspringende Teile (275) aufweist, welche in Auskehlungen (276) mit komplementärem Profil einsetzbar sind, die in den Patronenunterteilen (20) ausgeformt sind, wenn ein Patronenunterteil (20) gegenüber dem Verschiebearm (246) positioniert ist.

14. Vorrichtung nach Anspruch 6, dadurch gekennzeichnet, daß die Einrückvorrichtung aktiv ausgelegt ist und einen Elektromagneten aufweist.

15. Vorrichtung nach Anspruch 7, dadurch gekennzeichnet, daß die Einrückvorrichtung (258) passiv ausgelegt ist und ein mit zwei Paaren sich gegenüber liegender ebener Flächen versehenes Betätigungselement (280) aufweist, welches sich in dem Antriebszahnrad (271) dreht und mit einem kreuzförmigen Schaltrad (282) zusammenwirkt, welches vier stabile Positionen besitzt und bei jeder Umdrehung des Antriebszahnrads (271) unter der Einwirkung eines Fingers (283) eine Drehung um 90° ausführt, wodurch das Betätigungselement (280) entweder in einer in der Scheibe (270) eingelassenen Vertiefung (281a) oder in einer in der Platte (255) eingeschnittenen Vertiefung (281b) verriegelt wird.

16. Vorrichtung nach einem der Ansprüche 1 bis 5, dadurch gekennzeichnet, daß jedes Patronenunterteil (20) eine im wesentlichen ebene Übergangsfläche (71) zur mechanischen Positionierung und elektrischen Verbindung aufweist, die so ausgelegt ist, daß sie mit einer einzigen komplementären, im wesentlichen ebenen Übergangsfläche (70) zur mechanischen Positionierung und elektrischen Verbindung zusammenwirkt, welche auf Abstützeinrichtungen für die Einrichtungen (6) für den Verschiebeantrieb des Ofens (1) angeordnet ist.

17. Vorrichtung nach einem der Ansprüche 1 bis 16, dadurch gekennzeichnet, daß sie bei einem Ofen (1) eingesetzt ist, welcher in erste und zweite Blöcke (1a, 1b) unterteilt ist, die unabhängig voneinander mittels Verbindungselementen (101a, 10b) auf einem Ofenträger (6) mit einer Achse (106) angebracht sind, die in Arbeitsstellung parallel zur Achse (23) des Ofens (1") verläuft, wobei der vom Unterteil (21) der bearbeiteten Patrone (11) weiter entfernte zweite Ofenblock (1b) so angebracht ist, daß er um die zur Achse (23) des Ofens parallele Achse (106) drehbar ist, wenn dieser Block in einer Position steht, in der er keine Patrone enthält, und der zum Unterteil (21) der bearbeiteten Patrone (11) näher stehende erste Ofenblock (1a) so angeordnet ist, daß er dann, wenn der zweite Ofenblock (1b) eingezogen wurde, seine Verschiebung entlang der Achse (23) des Ofens (1) durch Verschwenken in der Weise ausführen kann, daß er neben dem zweiten eingezogenen Ofenblock (1b) positioniert wird.

**Claims**

1. A loader device for an automatic space furnace (1) for processing purposes having a geometrical longitudinal axis (23) and means (6) for driving the furnace (1) in translation in guided manner along said geometrical longitudinal axis (23), the loader device being disposed in the vicinity of the furnace (1) and comprising a cartridge-carrier carousel (9) whose axis of rotation (22) is parallel to the geometrical longitudinal axis (23) of the furnace (1) and which is provided with a set of cartridge-holders (20) in which sealed, closed cartridges (10) are removably mounted, with each cartridge being designed to contain a sample for processing in said space furnace (1) and being disposed in the carousel (9) parallel to its axis of rotation (22), a control mechanism (12) for imparting indexed rotary drive to the cartridge-holders and a transfer mechanism (200) which cooperates with each cartridge-holder (20) of the carousel (9) to enable each cartridge to be brought successively into a working position (11) in which the axis of the cartridge is in alignment with the geometrical axis (23) of the furnace (1), the loader device being characterised in that the carousel (9) is itself mounted to one side of the furnace (1), in that the transfer mechanism (200) includes a translation arm (246) extending perpendicularly to the axis of rotation (22) of the carousel (9), in that the control mechanism (12) for imparting rotary drive to the cartridge-holders and the transfer mechanism (200) are activated alternately by a single electric motor (50) and in that the single electric motor (50), the control mechanism (12) for imparting rotary drive to the cartridge-holders and the transfer mechanism (200) are disposed in the free central space of the cartridge-carrier carousel (9).

2. A device according to claim 1, characterised in that the carousel (9) and the control mechanisms (12, 200) for imparting rotary drive to the cartridge-holders and for transferring them are both placed inside a hermetic container (24) provided with a closeable lateral opening (25).

3. A device according to claim 1 or 2, characterised in that the control mechanism (12) for imparting rotary drive to the cartridge-holders comprises a shaft (250a) disposed perpendicularly to the translation arm (246), having one end disposed to receive rotary motion from an electric motor (50) and having its other end disposed to drive a Maltese cross device (53) acting on the cartridge-holders (20).

4. A device according to claim 3, characterised in that the Maltese cross mechanism (53) comprises a finger (247) for controlling rotation that acts on grooves (151) formed in the cartridge-holders (20) parallel to the axis (22) of the carousel, and a cam (249) co-operating with openings (248) formed in the cartridge-holders (20) to perform locking in each indexed position.

5. A device according to any one of claims 1 to 4, characterised in that the transfer mechanism (200) comprises at least two arms (256) hinged firstly to a stand (208) fixed to the bottom (207) of the carousel (9) and extending perpendicularly to said bottom (207), and secondly to the translation arm (246) to co-operate with the translation arm (246) to constitute a parallelogram linkage.

6. A device according to claim 5, characterised in that the transfer mechanism (200) comprises a guide (254) fixed to the translation arm (246) and extending perpendicularly thereto, and a finger (262) engaged in the guide (250) and secured to a plate (255) occupying a plane parallel to said stand (208) and capable of being selectively driven, under the control of a clutch device (258), from a driving toothed wheel (271) whose axis is perpendicular to the plane of the stand (208) and which meshes with a step-down gear wheel (52) disposed at the outlet from the electric motor (50).

7. A device according to claim 3 and claim 6, characterised in that the control mechanism (12) for imparting rotary drive to the cartridge-holders comprises a disk (270) extending in a plane parallel to the stand (208), which disk is secured to the shaft (250a) having the Maltese cross device (53) attached thereto and is capable of being selectively driven under the control of the clutch device (258) from the driving toothed wheel (271) when the plate (255) of the transfer mechanism (200) is itself declutched relative to the driving wheel (271).

8. A device according to claim 6 or 7, characterised in that resilient elements (257) are interposed between the guide (254) and the translation arm (246).

9. A device according to claim 7, characterised in that during two revolutions of the driving toothed wheel (271): the first revolution corresponds to the carousel rotating through one step and to the cartridge-holders (20) being locked in place, while the disk (270) which is secured to the shaft (250a) that is connected to the Maltese cross device (53) is clutched to the driving toothed wheel (271), and while the plate (255) of the transfer mechanism is declutched from the driving toothed wheel (271); and the second revolution corresponds to a step of extracting a cartridge (11) from the carousel (9), of processing the extracted cartridge (11) in the furnace, and of returning the cartridge, while the disk (270) which is secured to the shaft (250a) having the Maltese cross device (53) secured thereto is declutched from the driving toothed wheel (271), and while the plate (255) of the transfer mechanism is clutched to the driving toothed wheel (271).

10. A device according to claim 5, characterised in that the transfer mechanism (200) comprises a cam (262a) secured to one of the arms (256), and a finger (262) which acts on the cam (262a) and is secured to a first driving toothed wheel (271a) whose axis is perpendicular to the plane of the stand (208), and which meshes with a step-down gear wheel (52) disposed at the outlet from the electric motor (50).

11. A device according to claim 3 and claim 10, characterised in that the control mechanism (12) for imparting rotary drive to the cartridge-holders includes a second driving toothed wheel (271) whose axis is perpendicular to the plane of the stand (208), which has the same number of teeth as the first driving toothed wheel (271a), and which meshes therewith, the second driving toothed wheel (271) being secured to the shaft (250a) which has the Maltese cross device (53) attached thereto.

12. A device according to claim 11, characterised in that during one revolution of the first driving toothed wheel (271a), during the first half-revolution, the parallelogram linkage of the transfer mechanism (200) is held stationary in its retracted position by the cam (262a) having a semi-circular profile centred on the first drive wheel (271 a), while rotation of the first and second driving toothed wheels (271a, 271) causes the cartridge-holders to rotate through one step, and during the second half-revolution, rotation of the second driving toothed wheel (271) locks the carousel (9) in the position it has previously acquired, while rotation of the first driving toothed wheel (271a) drives the finger (262) along an arcuate return portion of the cam (262a) such that during a first half of the second half-revolution, the translation arm (246) advances to bring a cartridge (11) into the working position in the furnace, and during the second half of the second half-revolution, the translation arm (246) retracts, thereby returning the processed cartridge (11) to the carousel (9).

13. A device according to any one of claims 1 to 12, characterised in that the translation arm (246) has projecting portions (275) capable of being received in grooves of complementary profile (276) formed in the cartridge-holders (20), whenever a cartridge-holder (20) is positioned facing the translation arm (246).

14. A device according to claim 6, characterised in that the clutch device is of the active type and comprises an electromagnet.

15. A device according to claim 7, characterised in that the clutch device (258) is of the passive type and comprises an actuator element (280) provided with two pairs of opposite plane faces, which actuator element revolves in the driving toothed wheel (271) and co-operates with a cross-shaped wheel (282) which posses four stable positions and which, on each revolution of the driving toothed wheel (271), is rotated through 90° by means of a finger (283), thereby locking the actuator element (280), either in a recess (281a) formed in the disk (270), or else in a recess (281 b) formed in the plate (255).

16. A device according to any one of claims 1 to 5, characterised in that each cartridge-holder (20) comprises an essentially plane interface (71) for mechanical positioning and for electrical connection adapted to co-operate with a single, essentially plane complementary interface (70) for mechanical positioning and for electrical connection disposed on means for supporting the means (6) that drive the furnace (1) in translation.

**17.** A device according to any one of claims 1 to 16, characterised in that it is applied to a furnace (1) subdivided into first and second blocks (1a, 1b) that are independently mounted via respective connection elements (101a, 101b) on a furnace support (6) having an axis (106) parallel to the axis (23) of the furnace (1") in its working position, the second furnace block (1 b) that is further away from the holder (21) for the cartridge being processed (11) being mounted in such a manner as to be capable of pivoting about the axis (106) parallel to the axis (23) of the furnace when said block is in a position where it no longer contains the cartridge (11), while the first furnace block (1a), closer to the holder (21) for the cartridge being processed (11) is mounted so as to be capable of continuing its own displacement along the axis (23) of the furnace (1) after the second furnace block (1b) has been retracted by pivoting so as to take up a position adjacent said retracted second furnace block (1b).

FIG.2

FIG.1

**FIG.3**

## FIG.4

**FIG.5**

FIG.6

Rotation de la roue dentée

| | | | | | |
|0°|180°|360°|540°|720°|

Rotation d'un pas     Verrouillage

Extraction cartouche | Rétraction cartouche

Traitement

Disque 270    embrayé       débrayé

Plateau 255    débrayé       embrayé

# FIG.7

# FIG.12

# FIG.8

**FIG.9**

**FIG.10 A**

**FIG.10 B**

**FIG.10 C**

**FIG.11**

EP 0 682 222 B1

**FIG.13**

**FIG.14**

**FIG.15**

(Art antérieur)

**FIG.16**

(Art antérieur)

EP 0 682 222 B1

# FIG.17a
# FIG.17b
# FIG.17c

EP 0 682 222 B1